# EUROPÄISCHE PATENTSCHRIFT

(11) **EP 2 561 372 B1**
(45) Veröffentlichungstag und Bekanntmachung des Hinweises auf die Patenterteilung: **21.01.2015**
(21) Anmeldenummer: 11715408.8
(22) Anmeldetag: 09.04.2011
(51) Int. Cl.: G01R 31/00, G01R 31/28, G01R 31/36, H02J 7/34, B60L 3/00, G01R 31/02, G01R 31/42

(54) **HOCHVOLTSYSTEM FÜR EIN KRAFTFAHRZEUG UND VERFAHREN ZUR DIAGNOSE EINES HOCHVOLTSYSTEMS FÜR EIN KRAFTFAHRZEUG**
HIGH-VOLTAGE SYSTEM FOR A MOTOR VEHICLE AND METHOD FOR DIAGNOSING A HIGH-VOLTAGE SYSTEM FOR A MOTOR VEHICLE
SYSTÈME À HAUTE TENSION POUR UN VÉHICULE AUTOMOBILE ET PROCÉDÉ DE DIAGNOSTIC D'UN SYSTÈME À HAUTE TENSION POUR UN VÉHICULE AUTOMOBILE

(30) Priorität: 17.04.2010 DE 102010015312
(43) Veröffentlichungstag der Anmeldung: 27.02.2013
(73) Patentinhaber: Audi AG, 85045 Ingolstadt (DE)
(72) Erfinder: WOLF, Norbert, 85101 Lenting (DE)
(74) Vertreter: Herbst, Matthias Heinz
(86) Internationale Anmeldenummer: PCT/EP2011/001775
(87) Internationale Veröffentlichungsnummer: WO 2011/128046

(56) Entgegenhaltungen:
- EP-A1- 1 529 694
- EP-A1- 2 284 982
- DE-A1-102008 012 418
- US-A- 6 002 221

## Beschreibung

Die Erfindung betrifft ein Hochvoltsystem für ein Kraftfahrzeug, umfassend eine wenigstens eine Last, insbesondere einen Wechselrichter, über Leitungen versorgende Hochvoltbatterie, deren Spannung größer als 60 Volt ist, wenigstens ein Schaltmittel zur Trennung der Hochvoltbatterie von der Last, einen der Last parallel geschalteten Kondensator und eine Entladeschaltung zur Entladung des Kondensators mit einem Entladewiderstand und einem den Entladekreis schließenden Entladeschaltmittel, wobei das Hochvoltsystem eine Diagnoseeinrichtung mit einer Messeinrichtung zur Messung eines den Spannungsverlauf an dem Kondensator während des Entladevorgangs beschreibenden Spannungsverlaufs und einer Steuereinrichtung zur Auswertung dieses Spannungsverlaufs im Hinblick auf eine Fehlfunktion der Entladeschaltung aufweist, sowie ein Verfahren zur Diagnose eines solchen Hochvoltsystems.

Insbesondere in Hybridfahrzeugen oder Elektrofahrzeugen ist es heutzutage üblich, auch Hochvoltbatterien zu verwenden. Solche Hochvoltbatterien können Spannungen von größer als 60V, beispielsweise bis zu 300V, verwenden. Beispielsweise sind Kraftfahrzeuge mit einem Elektromotor bekannt, bei denen der Gleichstrom der Hochvoltbatterie zunächst über einen Wechselrichter, insbesondere einen Pulswechselrichter, in eine Wechselspannung umgewandelt wird, die zum Betrieb der entsprechenden Hochvoltsysteme im Kraftfahrzeug dient, wobei grundsätzlich selbstverständlich auch andere Lasten vorgesehen sein können. Dabei wird üblicherweise ein der Last, insbesondere also dem Wechselrichter, parallel geschalteter Kondensator (sogenannte Zwischenkreiskapazität) verwendet. Ein solcher Kondensator wird bei Einschalten der Hochspannungsversorgung, wozu üblicherweise wenigstens ein Schaltmittel in der Hochvoltbatterie verwendet wird, aufgeladen.

Bei solchen Spannungen, die größer als 60 V sind, ist grundsätzlich ein Sicherheitsaspekt zu beachten, da sie die Ursache für gefährliche Körperströme bei Berührung sein können. Im Übrigen gelten auch spezielle Schutzvorschriften hinsichtlich des Berührschutzes bei derartigen Spannungen. Es sind daher Vorrichtungen bekannt, um den Kondensator nach Trennung der Hochspannungsversorgung kontrolliert wieder entladen zu können. Solche Entladeschaltungen zur Entladung des Kondensators umfassen beispielsweise einen Entladewiderstand und ein den Entladekreis schließendes Entladeschaltmittel. Wird das Entladeschaltmittel geschlossen, so kann die Ladung des Kondensators über den Entladewiderstand kontrolliert abfließen, so dass nach Trennung der Hochspannungsversorgung keine Hochspannungen im Hochvoltsystem mehr verbleiben, die eine Gefahr bei Berühren darstellen könnten.

Ein solches Hochvoltsystem ist beispielsweise aus der DE 10 2008 012 418 A1 bekannt, worin ein Hochvoltsystem geschaffen werden soll, mittels dessen zuverlässig die Kontaktierung überprüft werden soll. Dafür wird dort jedoch zusätzliche Hardware zur Strommessung verwendet.

Wichtig in einem solchen Hochvoltsystem wäre es, vor allem die Funktionalität der Entladeschaltung diagnostizieren zu können, um das Risiko für Personen möglichst gering zu halten. Eine vollständige Diagnose der Funktionalität der Entladeschaltung ist jedoch im Stand der Technik ohne zusätzliche aufwendige Hardware noch nicht bekannt.

US 6,002,221 offenbart ein Vorgehen, bei dem eine Entladeschaltung, die parallel zu einem Wechselrichter und parallel zu einem Glättungskondensator geschaltet ist, in ihrer Funktion überprüft werden soll. Dabei soll bei einem Entladevorgang eine vorbestimmte Zeit abgewartet werden, bis eine Spannungsmessung stattfindet. Diese erste vorbestimmte Zeit entspricht der Zeit, in der üblicherweise die Entladeschaltung den Glättungskondensator entladen hat. Es wird überprüft, ob zu diesem Zeitpunkt die Kondensatorspannung größer oder gleich einem Referenzwert ist. Zweitens wird gemessen, ob die Kondensatorspannung bei Ablauf einer zweiten Zeitspanne, die die Entladung über einen zusätzlich vorgesehenen Entladewiderstand betrifft, die Kondensatorspannung gleich oder größer als der Referenzwert ist.

EP 1 529 694 A1 betrifft eine Leistungsversorgung für ein Kraftfahrzeug, wobei r Betrieb einer elektrisch betriebenen Bremse sichergestellt werden soll, indem eine Notstromversorgung mit einer Mehrzahl von Kondensatoren genutzt wird. Dort soll durch eine kurzeitige Unterbrechung des Entladevorgangs ein Spannungssprung beobachtet werden, aus dem die interne Kapazität und der interne Widerstand der Kondensatoreinheit bestimmt werden soll.

Der Erfindung liegt daher die Aufgabe zugrunde, ein Hochvoltsystem und ein Verfahren zur Diagnose eines Hochvoltsystems anzugeben, mit dem ohne großen Aufwand die Funktionalität der Entladeschaltung überwacht werden kann.

Zur Lösung dieser Aufgabe ist bei einem Hochvoltsystem der eingangs genannten Art erfindungsgemäß vorgesehen, dass die Steuereinrichtung zum kurzzeitigen Unterbrechen des Entladevorgangs für einen vorbestimmten Zeitraum durch Ansteuern des Entladeschaltmittels und zur Detektion einer Fehlfunktion bei Messung einer außerhalb eines Schwellbereichs um die zum Zeitpunkt der Unterbrechung vorliegende Spannung liegenden Spannung ausgebildet ist.

Es wird also vorgeschlagen, eine Diagnose dadurch vorzunehmen, dass der zeitliche Verlauf der Spannung am Kondensator selber bzw. ein anderer Spannungsverlauf, der den Spannungsverlauf an dem Kondensator nichtsdestotrotz beschreibt, zu betrachten. Der Begriff "den Spannungsverlauf an dem Kondensator beschreibender Spannungsverlauf" umfasst also auch den Spannungsverlauf am Kondensator selber. Gerade während eines Entladevorgangs lassen sich charakteristische Größen des Spannungsverlaufs, insbesondere auch die Reaktion des Spannungsverlaufs auf durch die Steuereinrichtung vorgenommene Einflüsse, worauf im Folgenden noch näher eingegangen werden wird, leicht ermittelt werden. Dies gilt insbesondere dann, wenn ein Hochvoltsystem mit einem an einem Batterieausgang angeordneten Vorschaltwiderstand zur kontrollierten Ladung der Kapazität verwendet wird.

Ein solcher Vorschaltwiderstand dient zum sogenannten "sanften" Einschalten des Hochvoltsystems. Über den Vorschaltwiderstand ist es nämlich möglich, eine kontrollierte Ladung von Zwischenkreiskapazitäten, also des Kondensators, vorzunehmen. Dabei sind beispielsweise Hochvoltbatterien denkbar, die drei Schaltmittel umfassen, von denen ein Schaltmittel der Leitung ohne Vorschaltwiderstand zugeordnet ist, wobei von den anderen beiden Schaltmitteln eines dem Vorschaltwiderstand zugeordnet ist, das andere den entsprechenden Pol der Batterie unmittelbar mit der Leitung verbinden kann. Dann wird seitens der Hochvoltbatterie zunächst das Schaltmittel an der Leitung ohne Vorschaltwiderstand und das dem Vorschaltwiderstand zugeordnete Schaltmittel geschlossen. Ist eine Mindestspannung erreicht, wird das dem Vorschaltwiderstand zugeordnete Schaltmittel wieder geöffnet und das die Leitung unmittelbar mit dem Pol der Batterie verbindende Schaltmittel geschlossen, so dass die Last dann direkt mit der Hochvoltbatterie verbunden ist.

Dabei ist der Vorschaltwiderstand üblicherweise kleiner als der Entladewiderstand; der Vorladewiderstand kann beispielsweise im Ohmbereich liegen, während der Entladewiderstand im Kiloohmbereich liegt. In solchen Fällen ist eine Diagnose der Entladeschaltung während des Ladevorganges nur schwer oder gar überhaupt nicht möglich, so dass die Diagnose erfindungsgemäß während des länger andauernden Entladungsvorgangs durchgeführt werden kann.

Die vorliegende Erfindung ermöglicht also eine Diagnose der Funktionalität der Entladeschaltung, so dass beispielsweise festgestellt werden kann, ob eine Entladung des Kondensators überhaupt nicht mehr möglich ist oder ob die Entladung dauerhaft aktiviert ist, worauf im Folgenden noch näher eingegangen werden wird.

Ein Vorteil des erfindungsgemäßen Hochvoltsystems ist es zudem, dass üblicherweise eine den Spannungsverlauf an dem Kondensator beschreibende Spannung häufig ohnehin bezüglich anderer Funktionen aufgenommen wird, das bedeutet, die entsprechende Messeinrichtung ist bereits vorgesehen. Wird nun noch die bereits vorhandene Steuereinrichtung, beispielsweise als allgemeine Steuereinrichtung für das Hochvoltsystem oder die Energieversorgung des Kraftfahrzeugs, zusätzlich dazu ausgebildet, die Auswertung des Spannungsverlaufs im Hinblick auf die Funktionalität der Entladeschaltung, also insbesondere während des Entladevorgangs, durchzuführen, so sind keinerlei zusätzliche Vorrichtungen notwendig - ohnehin vorhandene Hardware kann demnach für eine vorteilhafte weitere Funktionalität genutzt werden. Konkret kann also vorgesehen sein, dass die oder eine Steuereinrichtung zur Auswertung des Spannungsverlaufs im Hinblick auf wenigstens eine weitere Funktion des Hochvoltsystems und/oder des Kraftfahrzeugs ausgebildet ist, mithin eine ohnehin vorhandene Messeinrichtung verwendet wird. Zweckmäßigerweise kann die Messeinrichtung den Spannungsverlauf in einem Elektromotor des Kraftfahrzeugs messen und/oder die Steuereinrichtung zur Regelung des Elektromotors des Kraftfahrzeugs in Abhängigkeit des Spannungsverlaufs ausgebildet sein. Während eine derartige Regelung eines Elektromotors durch die Messung von Spannungen innerhalb des Elektromotors selber grundsätzlich bereits bekannt ist, schlägt die vorliegende Erfindung also vor, diese bereits vorhandene Mess- und Auswerteanordnung auch zur Diagnose der Entladeschaltung zu verwenden, wobei ausgenutzt wird, dass der Spannungsverlauf im Elektromotor mit dem Spannungsverlauf am Kondensator korrespondiert.

Bezüglich der Auswertung des Spannungsverlaufs beim Entladevorgang, also nach Trennung der Hochspannungsversorgung, kann vorgesehen sein, dass die Steuereinrichtung zur Detektion einer Fehlfunktion bei Überschreitung eines Zeitschwellwerts durch die bis zum Erreichen einer unterhalb der Ausgangsspannung der Hochvoltbatterie liegenden Grenzspannung nach Schließen des Entladeschaltmittels vergehende Zeit ausgebildet ist. Auf diese Weise können also Fehlerfälle einer ersten Art festgestellt werden, in denen eine Entladung des Kondensators nicht mehr oder nur zu langsam möglich ist. Bei korrekter Funktionalität der Entladeschaltung muss die nach dem Schließen des Entladeschaltmittels vergangene Zeit bis zum Erreichen einer Grenzspannung, beispielsweise von 60 V, kleiner als der Zeitschwellwert sein. Ein solcher Fehlerfall erster Art tritt beispielsweise auf, wenn das Entladeschaltmittel nicht mehr geschlossen werden kann. Es sei an dieser Stelle jedoch angemerkt, dass der Fehlerfall auch detektiert wird, wenn die Hochvoltbatterie nicht mehr von der Last getrennt werden kann, das bedeutet, die Schaltmittel der Hochvoltbatterie beispielsweise nicht mehr geöffnet werden können. Es muss daher, um sicherzustellen, dass der Fehler tatsächlich in der Entladeschaltung liegt, festgestellt werden, dass die Hochvoltbatterie bereits die Schaltmittel geöffnet hat. Dieser Zustand kann beispielsweise über ein Bussystem, insbesondere einen CAN-Bus, von der Hochvoltbatterie der Steuereinrichtung mitgeteilt werden. Ist es also auf diese Weise möglich, Fehlfunktionen in der Hochvoltbatterie auszuschließen, so kann der Fehler auf die Entladeschaltung lokalisiert werden.

Erfindungsgemäß ist vorgesehen, dass die Steuereinrichtung zum kurzzeitigen Unterbrechen des Entladevorgangs für einen vorbestimmten Zeitraum durch Ansteuern des Entladeschaltmittels und zur Detektion einer Fehlfunktion bei Messung einer außerhalb eines Schwellbereichs um die zum Zeitpunkt der Unterbrechung vorliegende Spannung liegenden Spannung ausgebildet ist. Auf diese Weise kann also ein Fehlerfall zweiter Art detektiert werden, nämlich, dass die Entladung dauerhaft aktiviert ist. Dies kann beispielsweise der Fall sein, wenn das Entladeschaltmittel nicht mehr geöffnet werden kann. Dazu wird versucht, den Entladevorgang für einen kurzen, vorbestimmten Zeitraum zu unterbrechen, indem das Entladeschaltmittel entsprechend durch die Steuereinrichtung angesteuert wird. Die sich nach dem (gegebenenfalls vermeintlichen) Öffnen des Entladeschaltmittels einstellende Spannung darf sich innerhalb des Zeitraums nur in einem maximal zulässigen Schwellbereich ändern, damit von einer normalen Funktion auszugehen ist.

In weiterer Ausgestaltung der vorliegenden Erfindung kann vorgesehen sein, dass das Hochvoltsystem eine Speichereinrichtung zur Speicherung der Zahl von Fehlfunktionen, insbesondere der Zahl bezogen auf die Art der Fehlfunktion, aufweist. Dabei wird üblicherweise vorgesehen sein, dass nur aufeinanderfolgende oder zumindest innerhalb einer gewissen Zeitspanne liegende Fehlfunktionen, insbesondere Fehlfunktionen einer Art, zusammengezählt werden. Ein solches Vorgehen ist besonders vorteilhaft, wenn die Steuereinrichtung zur Ausgabe einer Fehlermeldung bei Überschreitung eines Sicherheitsgrenzwerts durch die oder eine Zahl von Fehlfunktionen ausgebildet ist. Auf diese Weise wird eine Entprellung der Diagnose erreicht, indem überprüft wird, ob die Fehlfunktion über mehrere Zyklen anliegt. Beispielsweise kann die Fehlermeldung erzeugt werden, wenn eine Fehlfunktion einer Art in drei aufeinanderfolgenden Zyklen, also drei Entladevorgängen, detektiert wurde. So wird eine Fehldiagnose vermieden, indem Fehlfunktionen zunächst intern gespeichert werden und nur nach einer Entprellung die Steuereinrichtung tatsächlich eine entsprechende Ausgabe einer Fehlermeldung veranlasst.

Zweckmäßigerweise kann vorgesehen sein, dass die Diagnoseeinrichtung zur Durchführung einer Auswertung bei jeder Trennung der Hochspannungsversorgung ausgebildet ist, insbesondere bei jedem Deaktivieren der Zündung. So wird kontinuierlich die Funktion der Entladeschaltung überprüft. Gekoppelt werden kann die Überprüfung beispielsweise an das Anliegen eines Signals an einer bestimmten Klemme, wenn der Zündschlüssel in eine andere Position bewegt wird oder dergleichen.

Neben dem Hochvoltsystem betrifft die Erfindung auch ein Verfahren zur Diagnose eines Hochvoltsystems für ein Kraftfahrzeug, insbesondere für das erfindungsgemäße Hochvoltsystem, gemäß Anspruch 9. Sämtliche Ausführungen bezüglich des erfindungsgemäßen Hochvoltsystems lassen sich analog auf das erfindungsgemäße Verfahren übertragen. Auch das erfindungsgemäße Verfahren ermöglicht es also, vorteilhaft eine Diagnose der Funktionalität der Entladeschaltung durchzuführen, insbesondere unter Verwendung bereits vorhandener Vorrichtungen/Hardware. So kann vorgesehen sein, dass der Spannungsverlauf auch im Hinblick auf wenigstens eine weitere Funktion des Hochvoltsystems und/oder Kraftfahrzeugs, insbesondere bezüglich der Regelung eines Elektromotors des Kraftfahrzeugs, ausgewertet wird. Eine ohnehin vorhandene Messeinrichtung mit einer ohnehin vorhandenen Steuereinrichtung können folglich zur Realisierung einer Zusatzfunktion verwendet werden.

Wie bereits erwähnt, können beispielsweise zwei verschiedene Arten von Fehlfunktionen detektiert werden. So kann vorgesehen sein, dass bei Überschreitung eines Zeitschwellwerts durch die bis zum Erreichen einer unterhalb der Ausgangsspannung der Hochvoltbatterie liegenden Grenzspannung nach Schließen des Entladeschaltmittels vergehende Zeit eine Fehlfunktion detektiert wird. So kann beispielsweise festgestellt werden, ob ein Entladen nicht mehr oder nur zu langsam möglich ist. In jedem Fall ist vorgesehen, dass der Entladevorgang für einen vorbestimmten Zeitraum durch Ansteuern des Entladeschaltmittels unterbrochen wird und bei Messung einer außerhalb eines Schwellbereichs um die zum Zeitpunkt der Unterberechung vorliegende Spannung liegenden Spannung eine Fehlfunktion detektiert wird. Ein solcher Fall würde bedeuten, dass die Entladung dauerhaft aktiviert ist.

Analog dem Hochvoltsystem kann auch beim Verfahren vorgesehen sein, dass erst bei Überschreitung eines Sicherheitsgrenzwerts für die Zahl der Fehlfunktionen, insbesondere die Zahl von Fehlfunktionen einer Art, eine Fehlermeldung erzeugt wird. Dies kann beispielsweise dann geschehen, wenn bei drei aufeinanderfolgenden Zyklen eine Fehlfunktion der gleichen Art festgestellt wird. In diesem Zusammenhang wie auch grundsätzlich kann vorgesehen sein, dass bei jeder Trennung der Hochvoltbatterie von der Last die Messung und die Auswertung durchgeführt werden.

Schließlich betrifft die Erfindung noch ein Kraftfahrzeug, das mit einem erfindungsgemäßen Hochvoltsystem ausgestattet ist. Auch hierauf lassen sich sämtliche bislang getätigten Ausführungen übertragen.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: ein erfindungsgemäßes Hochvoltsystem,
- Fig. 2: einen Spannungsverlauf während eines typischen Entladevorgangs,
- Fig. 3: einen Spannungsverlauf während eines unterbrochenen Entladevorgangs, und
- Fig. 4: ein erfindungsgemäßes Kraftfahrzeug.

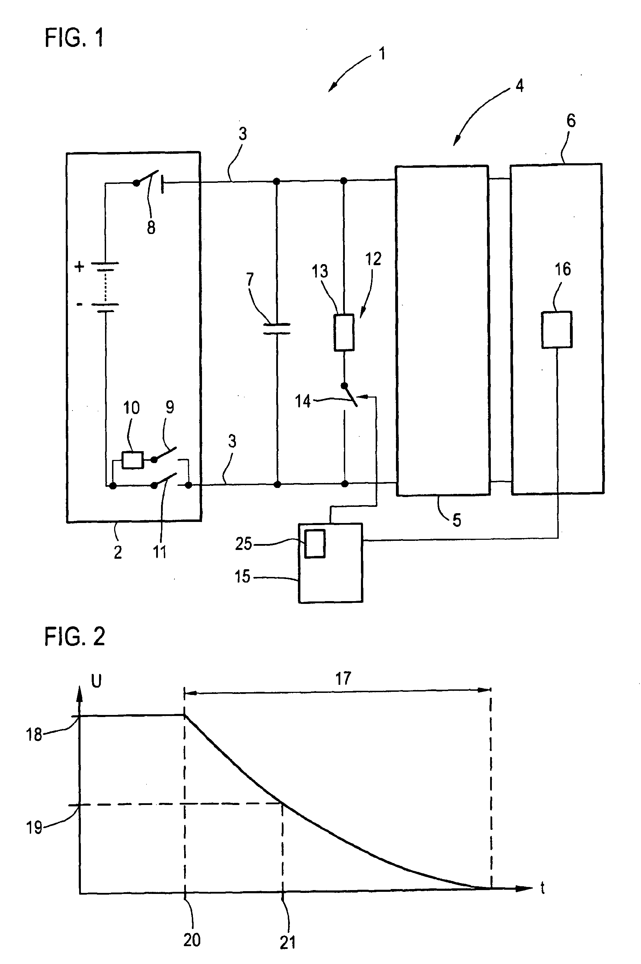

Figur 1 zeigt ein erfindungsgemäßes Hochvoltsystem 1. Es umfasst zunächst eine Hochvoltbatterie 2, die über Leitungen 3 an eine allgemein mit 4 bezeichnete Last angeschlossen werden können, hier konkret einen PulsWechselrichter 5, der einem Elektromotor 6 des Kraftfahrzeugs vorgeschaltet ist. Zudem enthält der gebildete Zwischenkreis einen Kondensator 7, also eine Zwischenkreiskapazität.

Wird die Hochspannungsversorgung eingeschaltet, beispielsweise durch Drehen eines Zündschlüssels oder dergleichen, so ist zunächst ein "sanftes" Einschalten vorgesehen, um den Kondensator 7 kontrolliert zu laden. Hierzu wird seitens der Hochvoltbatterie 2 zunächst das Schaltmittel 8 sowie das Schaltmittel 9, das einem Vorschaltwiderstand 10 zugeordnet ist, geschlossen. Ist eine Mindestspannung erreicht, wird das Schaltmittel 11 geschlossen und das Schaltmittel 9 wieder geöffnet, so dass die Last 4 direkt mit der Hochvoltbatterie 2 verbunden wird. Die Schaltmittel 8, 9 und 11 können beispielsweise als Schütze realisiert werden.

Wird die Hochvoltbatterie 2 wieder von der Last 4 getrennt, also eine Trennung der Hochspannungsversorgung ausgelöst, beispielsweise durch wiederum ein entsprechendes Drehen eines Zündschlüssels, so werden die Schaltmittel 8 und 11 geöffnet, so dass die Last nicht mehr mit der Spannungsquelle Hochvoltbatterie 2 elektrisch verbunden ist. Dabei würde jedoch grundsätzlich eine Ladung auf den Kondensator 7 verbleiben, was aus Gründen des Personenschutzes vermieden werden soll.

Das Hochvoltsystem 1 umfasst daher ferner eine Entladeschaltung 12 mit einem Entladewiderstand 13 und einem Entladeschaltmittel 14, welches über eine Steuereinrichtung 15 angesteuert werden kann, beispielsweise, nachdem die Hochvoltbatterie 2 über einen Fahrzeugbus, beispielsweise einen CAN-Bus, mitgeteilt hat, dass die Schaltmittel 8 und 11 geöffnet wurden. Während der Entladewiderstand ein Widerstand im Kiloohmbereich ist, ist der Vorschaltwiderstand 10 ein Widerstand im Ohmbereich, das bedeutet im Übrigen, dass der Ladevorgang sehr schnell abläuft.

Aufgabe der Entladeschaltung 12 ist es, die nach dem Trennen der Hochspannungsversorgung am Kondensator 7 verbleibende Zwischenkreisspannung innerhalb kurzer Zeit auf einen Wert zu reduzieren, der kleiner als die Berührschutzspannung (60 V) ist. Damit soll sichergestellt werden, dass keine Personengefährdung durch offene Leitungen mit gefährlicher Spannung eintreten kann. Hierzu wird das Entladeschaltmittel 14 geschlossen und die Ladungen des Kondensators 7 fließen über den Entladungswiderstand 13 ab.

Das erfindungsgemäße Hochvoltsystem 1 umfasst nun zusätzlich eine Diagnoseeinrichtung zur Detektion von Fehlfunktionen der Entladeschaltung 12, das bedeutet, es können verschiedene Fehlerfälle festgestellt werden, indem die Funktionalität der Entladeschaltung 12 nicht wie gewünscht gegeben ist.

Dazu ist nun eine Messeinrichtung 16 innerhalb des Elektromotors 6 vorgesehen, die dort anliegende Spannungen messen kann. Solche Messeinrichtungen 16 sind meist ohnehin vorgesehen, da die Steuereinrichtung 15 die Regelung des Elektromotors 6 über die dort anliegenden Spannungen bzw. Spannungsverläufe übernimmt. In diesem Ausführungsbeispiel wird nun ausgenutzt, dass die durch die Messeinrichtung 16 aufgenommene Spannungsverlauf mit dem Spannungsverlauf am Kondensator 7 korreliert. Daher wird die Spannung mit der Messeinrichtung 16 auch dann gemessen und der Steuereinrichtung 15 zugeführt, wenn gerade ein Entladevorgang über die Entladeschaltung 12 stattfindet, die Hochvoltversorgung also abgetrennt ist. Der sich ergebende, während des Entladevorgangs aufgenommene Spannungsverlauf wird von der Steuereinrichtung 15 im Hinblick auf Fehlfunktionen der Entladeschaltung 12 ausgewertet. Diese Auswertung, also Diagnose, erfolgt jedes mal, wenn die Hochspannungsversorgung getrennt wird, also beispielsweise anhand einer Deaktivierung der Zündung oder dergleichen detektiert werden kann und ja ohnehin detektiert wird, da die Steuereinrichtung 15 das Entladeschaltmittel 14 in diesem Fall ohnehin ansteuern muss. Jeder Entladezyklus wird also vermessen und ausgewertet.

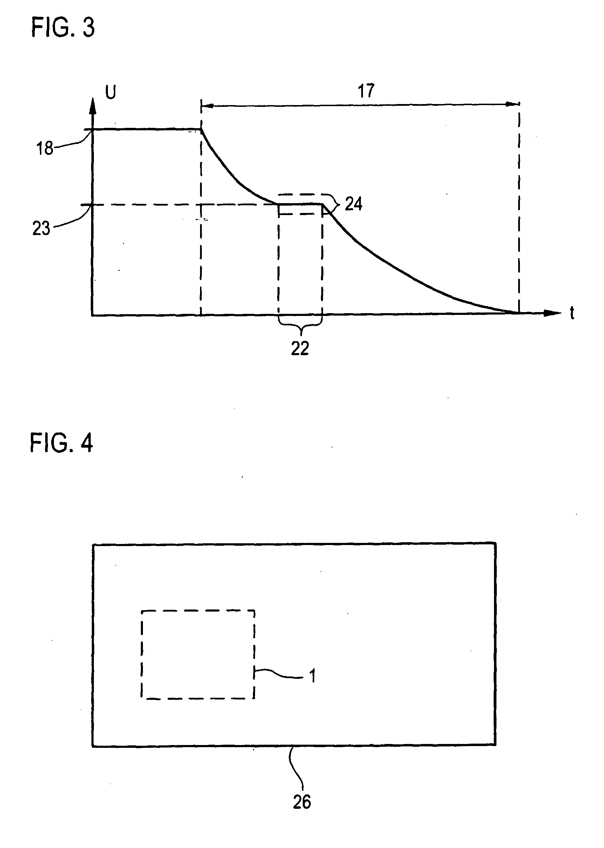

Die konkrete Art der Auswertung soll nun im Hinblick auf die Figuren 2 und 3 näher erläutert werden. Fig. 2 zeigt einen typischen Spannungsverlauf während eines Entladevorgangs 17, wobei in den Graphen die Spannung gegen die Zeit aufgetragen ist. Die von der Hochvoltbatterie 2 gelieferte Spannung 18 bietet ersichtlich den Startpunkt; nach Schließen des Entladeschaltmittels 14 fällt üblicherweise die Spannung während des Entladevorgangs 17 ab. Zur Auswertung des gemessenen Spannungsverlaufs ist nun vorgesehen, die Zeit zu betrachten, die vergeht, bis eine unterhalb der Ausgangsspannung 18 der Hochvoltbatterie 2 liegende Grenzspannung 19 erreicht ist. Wird also zum Zeitpunkt 20 die Hochspannungsversorgung getrennt und das Entladeschaltmittel 14 geschlossen, und ist zum Zeitpunkt 21 die Grenzspannung 19 erreicht, so wird die Differenz der Zeiten 20 und 21 betrachtet. Überschreitet dieses Zeitdifferenz einen Zeitschwellwert, so liegt ein Fehlerfall vor. Auf diese Weise können Fehlerfälle erster Art detektiert werden, in denen ein Entladen gänzlich unmöglich ist oder zumindest zu langsam erfolgt. Ein derartiger Fehlerfall erster Art kann beispielsweise dann auftreten, wenn sich das Entladeschaltmittel 14 nicht mehr schließen lässt.

Grundsätzlich kann solch ein Fehlerfall erster Art auch dann auftreten, wenn die Schaltmittel 8 und 11 der Hochvoltbatterie 2 nicht mehr zu öffnen sind. Es wird jedoch davon ausgegangen, dass die Hochvoltbatterie 2 über den CAN-Bus erst dann ein entsprechendes Signal sendet, wenn die Schaltmittel 8 und 11 geöffnet sind, so dass auf diese Weise sichergestellt werden kann, dass der Fehler nicht dort liegt und tatsächlich eine Diagnose der Entladeschaltung 12 stattfindet.

Fig. 3 zeigt, wie ein Fehlerfall zweiter Art festgestellt werden kann. Dazu ist vorgesehen, dass während des Entladevorgangs 17 die Steuereinrichtung 15 den Entladevorgang für einen vorbestimmten Zeitraum 22 unterbricht, indem sie das Entladeschaltmittel 14 so ansteuert, dass es für diesen vorbestimmten Zeitraum 22 geöffnet wird. Zum Beginn dieses Zeitraums 22 liegt nun eine bestimmte Spannung 23 vor. Die Steuereinrichtung 15 überprüft im Rahmen der Auswertung nun, ob die gemessene Spannung während des Zeitraums 22 innerhalb eines Schwellbereichs 24 um die Spannung 23 verbleibt. Wird eine Spannung außerhalb dieses Schwellbereichs, insbesondere niedriger als die untere Grenze des Schwellbereichs 24, gemessen, so liegt ein Fehlerfall zweiter Art vor. Ein solcher Fehlerfall kann bedeuten, dass die Entladung dauerhaft aktiviert ist. Er liegt beispielsweise dann vor, wenn das Entladeschaltmittel 14 immer geschlossen ist.

Es sei an dieser Stelle noch angemerkt, dass selbstverständlich die Detektion beider Fehlerfälle während eines Entladevorgangs 17 realisiert werden kann, beispielsweise, indem einfach der Zeitraum 22 bei der Bestimmung des Zeitschwellwerts berücksichtigt wird.

Wird durch die Steuereinrichtung 15 eine Fehlfunktion festgestellt, so wird dies unter Kennzeichnung der Art der Fehlfunktion in einer internen Speichereinrichtung 25 (Fig. 1) gespeichert. Aufeinanderfolgende detektierte Fehlfunktionen werden in der Speichereinrichtung 25 aufaddiert. Erst dann, wenn eine Fehlfunktion einer bestimmten Art über mehrere Zyklen, im vorliegenden über drei Zyklen, vorliegt, wird tatsächlich eine Fehlermeldung von der Steuereinrichtung 15 gegeben. Diese Maßnahme dient der Entprellung der Fehlerdetektion. Beispielsweise kann vorgesehen sein, dass immer dann, wenn eine Fehlfunktion im darauffolgenden Zyklus nicht detektiert wird, der entsprechende Eintrag in der Speichereinrichtung 25 wieder gelöscht wird, es ist jedoch auch denkbar, dass immer vorbestimmte Zeitspannen berücksichtigt werden, in denen nur eine bestimmte Zahl von Fehlfunktionen einer bestimmten Art auftreten darf.

Fig. 4 zeigt schließlich die Prinzipskizze eines erfindungsgemäßen Kraftfahrzeugs 26. Es umfasst ein erfindungsgemäßen Hochvoltsystem 1. Das Kraftfahrzeug 26 kann beispielsweise ein Hybridfahrzeug oder ein Elektrofahrzeug sein.

## Patentansprüche

1. Hochvoltsystem (1) für ein Kraftfahrzeug (26), umfassend eine wenigstens eine Last (4), insbesondere einen Wechselrichter (5), über Leitungen (3) versorgende Hochvoltbatterie (2), deren Spannung größer als 60 Volt ist, wenigstens ein Schaltmittel (8, 9, 11) zur Trennung der Hochvoltbatterie (2) von der Last (4), einen der Last (4) parallel geschalteten Kondensator (7) und eine Entladeschaltung (12) zur Entladung des Kondensators (7) mit einem Entladewiderstand (13) und einem den Entladekreis schließenden Entladeschaltmittel (14),
wobei das Hochvoltsystem (1) eine Diagnoseeinrichtung mit einer Messeinrichtung (16) zur Messung eines den Spannungsverlauf an dem Kondensator (7) während des Entladevorgangs (17) beschreibenden Spannungsverlaufs und einer Steuereinrichtung (15) zur Auswertung dieses Spannungsverlaufs im Hinblick auf eine Fehlfunktion der Entladeschaltung (12) aufweist,
**dadurch gekennzeichnet,**
**dass** die Steuereinrichtung (15) zum kurzzeitigen Unterbrechen des Entladevorgangs (17) für einen vorbestimmten Zeitraum (22) durch Ansteuern des Entladeschaltmittels (14) und zur Detektion einer Fehlfunktion bei Messung einer außerhalb eines Schwellbereichs (24) um die zum Zeitpunkt der Unterbrechung vorliegende Spannung (23) liegenden Spannung ausgebildet ist.

2. Hochvoltsystem nach Anspruch 1,
**dadurch gekennzeichnet,**
**dass** die Steuereinrichtung (15) zur Detektion einer Fehlfunktion bei Überschreitung eines Zeitschwellwerts durch die bis zum Erreichen einer unterhalb der Ausgangsspannung (18) der Hochvoltbatterie (2) liegenden Grenzspannung (19) nach Schließen des Entladeschaltmittels (14) vergehende Zeit ausgebildet ist.

3. Hochvoltsystem nach einem der vorangehenden Ansprüche,
**dadurch gekennzeichnet,**
**dass** es eine Speichereinrichtung (25) zur Speicherung der Zahl von Fehlfunktionen, insbesondere der Zahl bezogen auf die Art der Fehlfunktion, aufweist.

4. Hochvoltsystem nach Anspruch 3,
**dadurch gekennzeichnet,**
**dass** die Steuereinrichtung (15) zur Ausgabe einer Fehlermeldung bei Überschreitung eines Sicherheitsgrenzwerts durch die oder eine Zahl von Fehlfunktionen ausgebildet ist.

5. Hochvoltsystem nach einem der vorangehenden Ansprüche,
**dadurch gekennzeichnet,**
**dass** die Diagnoseeinrichtung zur Durchführung einer Auswertung bei jeder Trennung der Hochspannungsbatterie (2) von der Last (4) ausgebildet ist, insbesondere bei jedem Deaktivieren der Zündung.

6. Hochvoltsystem nach einem der vorangehenden Ansprüche,
**dadurch gekennzeichnet,**
**dass** die oder eine Steuereinrichtung (15) zur Auswertung des Spannungsverlaufs im Hinblick auf wenigstens eine weitere Funktion des Hochvoltsystems (2) und/oder des Kraftfahrzeugs (26) ausgebildet ist.

7. Hochvoltsystem nach Anspruch 6,
**dadurch gekennzeichnet,**
**dass** die Messeinrichtung (16) den Spannungsverlauf in einem Elektromotor (6) des Kraftfahrzeugs (26) misst und/oder die Steuereinrichtung (15) zur Regelung des Elektromotors (6) des Kraftfahrzeugs (26) in Abhängigkeit des Spannungsverlaufs ausgebildet ist.

8. Hochvoltsystem nach einem der vorangehenden Ansprüche, **gekennzeichnet durch** einen an einem Batterieausgang angeordneten Vorschaltwiderstand (10) zur kontrollierten Ladung der Kapazität (7).

9. Verfahren zur Diagnose eines Hochvoltsystems für ein Kraftfahrzeug, insbesondere einem Hochvoltsystem nach einem der Ansprüche 1 bis 6, umfassend eine wenigstens eine Last, insbesondere einen Wechselrichter, über Leitungen versorgende Hochvoltbatterie, deren Spannung größer als 60 Volt ist, wenigstens ein Schaltmittel zur Trennung der Hochvoltbatterie von der Last, einen der Last parallel geschalteten Kondensator und eine Entladeschaltung zur Entladung des Kondensators mit einem Entladewiderstand und einem den Entladekreis schließenden Entladeschaltmittel,
wobei ein den Spannungsverlauf an dem Kondensator während des Entladevorgangs beschreibender Spannungsverlauf gemessen und im Hinblick auf eine Fehlfunktion der Entladeschaltung ausgewertet wird,
**dadurch gekennzeichnet,**
**dass** der Entladevorgang für einen vorbestimmten Zeitraum durch Ansteuern des Entladeschaltmittels unterbrochen wird und bei Messung einer außerhalb eines Schwellbereichs um die zum Zeitpunkt der Unterbrechung vorliegende Spannung liegenden Spannung eine Fehlfunktion detektiert wird.

10. Verfahren nach Anspruch 9,
**dadurch gekennzeichnet,**
**dass** bei Überschreitung eines Zeitschwellwerts durch die bis zum Erreichen einer unterhalb der Ausgangsspannung der Hochvoltbatterie liegenden Grenzspannung nach Schließen des Entladeschaltmittels vergehende Zeit eine Fehlfunktion detektiert wird.

11. Verfahren nach einem der Ansprüche 9 oder 10,
**dadurch gekennzeichnet,**
**dass** erst bei Überschreitung eines Sicherheitsgrenzwerts für die Zahl der Fehlfunktionen, insbesondere die Zahl von Fehlfunktionen einer Art, eine Fehlermeldung erzeugt wird.

12. Verfahren nach einem der Ansprüche 9 bis 11,
**dadurch gekennzeichnet,**
**dass** bei jeder Trennung der Hochspannungsbatterie von der Last die Messung und die Auswertung durchgeführt werden.

13. Verfahren nach einem der Ansprüche 9 bis 12,
**dadurch gekennzeichnet,**
**dass** der Spannungsverlauf auch im Hinblick auf wenigstens eine weitere Funktion des Hochvoltsystems und/oder Kraftfahrzeugs, insbesondere bezüglich der Regelung eines Elektromotors des Kraftfahrzeugs, ausgewertet wird.

14. Kraftfahrzeug (26), umfassend ein Hochvoltsystem (1) nach einem der Ansprüche 1 bis 8.

## Claims

1. High-voltage system (1) for a motor vehicle (26), comprising a high-voltage battery (2) having a voltage greater than 60 V and supplying power to at least one load (4), in particular an inverter (5), via cables (3), at least one switching means (8, 9, 11) for disconnecting the high-voltage battery (2) from the load (4), a capacitor (7) connected in parallel with the load (4), and a discharge circuit (12) for discharging the capacitor (7), having a discharge resistor (13) and a discharge switching means (14) closing the discharge circuit, the high voltage system (1) comprising a diagnostic device having a measuring device (16) for measuring a voltage curve representative of a voltage curve on the capacitor (7) during a discharge process (17), and a control device (15) for evaluating this voltage curve in relation to a malfunction of the discharge circuit (12), **characterised in that** the control device (15) is configured to briefly interrupt the discharge process (17) for a predetermined time (22) by controlling the discharge switching means (14) and to detect a malfunction upon measuring a voltage lying outside a threshold range (24) around the voltage (23) that is present at the time of the interruption.

2. High-voltage system according to claim 1, **characterised in that** the control device (15) is configured to detect a malfunction when the time which elapses between the discharge switching means (14) being closed and a limit voltage (19) below the output voltage (18) of the high-voltage battery (2) being reached exceeds a time threshold value.

3. High-voltage system according to either of the preceding claims, **characterised in that** it comprises a storage device (25) for storing the number of malfunctions, in particular the number based on the type of malfunction.

4. High-voltage system according to claim 3, **characterised in that** the control device (15) is configured to output an error message when the or a number of malfunctions exceeds a safety limit value.

5. High-voltage system according to any of the preceding claims, **characterised in that** the diagnostic device is configured to carry out an evaluation at each disconnection of the high-voltage battery (2) from the load (4), in particular at each deactivation of the ignition.

6. High-voltage system according to any of the preceding claims, **characterised in that** the or a control device (15) is configured to the evaluate the voltage curve with respect to at least one additional function of the high-voltage system (2) and/or the motor vehicle (26).

7. High-voltage system according to claim 6, **characterised in that** the measuring device (16) measures the voltage curve in an electric motor (6) of the motor vehicle (26) and/or the control device (15) is configured to control the electric motor (6) of the motor vehicle (26) depending on the voltage curve.

8. High-voltage system according to any of the preceding claims, **characterised by** a series resistor (10) connected to an output of the battery for controlled charging of the capacitor (7).

9. Method for diagnosing a high-voltage system for a motor vehicle, in particular a high-voltage system according to any of claims 1 to 6, comprising a high-voltage battery having a voltage greater than 60 V and supplying power to at least one load, in particular an inverter, via cables, at least one switching means for disconnecting the high-voltage battery from the load, a capacitor connected in parallel with the load, and a discharge circuit for discharging the capacitor comprising a discharge resistor and a discharge switching means which closes the discharge circuit, a voltage curve representative of the voltage curve on the capacitor during the discharge process being measured and being evaluated in relation to a malfunction of the discharge circuit, **characterised in that** the discharge process is interrupted for a predetermined time by controlling the discharge switching means, and a malfunction is detected upon measuring a voltage lying outside a threshold range around the voltage that is present at the time of the interruption.

10. Method according to claim 9, **characterised in that** a malfunction is detected when the time which elapses between the discharge switching means being closed and a limit voltage below the output voltage of the high-voltage battery being reached exceeds a time threshold value.

11. Method according to either claim 9 or claim 10, **characterised in that** an error message is generated only when a safety limit value for the number of malfunctions, in particular the number of malfunctions of one type, is exceeded.

12. Method according to any of claims 9 to 11, **characterised in that** the measurement and the evaluation are performed each time the high-voltage battery is disconnected from the load.

13. Method according to any of claims 9 to 12, **characterised in that** the voltage curve is also evaluated with respect to at least one additional function of the high-voltage system and/or the motor vehicle, in particular in relation to the control of an electric motor of the motor vehicle.

14. Motor vehicle (26) comprising a high-voltage system (1) according to any of claims 1 to 8.

## Revendications

1. Système haute tension (1) pour un véhicule automobile (26), comprenant une batterie haute tension (2) alimentant au moins une charge (4), en particulier un onduleur (5), via des lignes (3), batterie dont la tension est supérieure à 60 volts, au moins un commutateur (8, 9, 11) pour séparer la batterie haute tension (2) de la charge (4), un condensateur (7) commuté en parallèle avec la charge (4) et un circuit de décharge (12) pour décharger le condensateur (7) par une résistance de décharge (13) et un commutateur de décharge (14) fermant le circuit de décharge,
dans lequel le système haute tension (1) présente un dispositif de diagnostic avec un dispositif de mesure (16) pour mesurer la courbe de tension décrivant la variation de tension sur le condensateur (7) au cours de la phase de décharge (17) et un dispositif de commande (15) pour évaluer cette variation de tension au regard d'un fonctionnement défectueux du circuit de décharge (12),
**caractérisé en ce que** :
le dispositif de commande (15) est conformé pour interrompre instantanément la phase de décharge (17) pendant un intervalle de temps prédéterminé (22) par commande du commutateur de décharge (14) et pour détecter un fonctionnement défectueux lors de la mesure d'une tension (23) qui se trouve en dehors d'une zone de seuil (24) au regard de la tension apparaissant au moment de l'interruption.

2. Système haute tension selon la revendication 1, **caractérisé en ce que** :
le dispositif de commande (15) est conformé pour la détection d'un fonctionnement défectueux lors du dépassement d'un valeur de seuil temporel par le temps s'écoulant jusqu'à atteindre une tension limite (19) se situant en dessous de la tension de sortie (18) de la batterie haute tension (2) après fermeture du commutateur de décharge (14).

3. Système haute tension selon l'une quelconque des revendications précédentes,
**caractérisé en ce que** :
il présente un dispositif de mémorisation (25) pour mémoriser le nombre de fonctionnements défectueux, en particulier le nombre par rapport au type de fonctionnement défectueux.

4. Système haute tension selon la revendication 3, **caractérisé en ce que** :
le dispositif de commande (15) est conformé pour délivrer un message d'erreur lors du dépassement d'une valeur de seuil de sécurité par le ou un nombre de fonctionnements défectueux.

5. Système haute tension selon l'une quelconque des revendications précédentes,
**caractérisé en ce que** :
le dispositif de diagnostic est conformé pour réaliser une évaluation lors de chaque séparation de la batterie haute tension (2) de la charge (4), en particulier lors de chaque désactivation de l'allumage.

6. Système haute tension selon l'une quelconque des revendications précédentes,
**caractérisé en ce que** :
le ou un dispositif de commande (15) est conformé pour évaluer la variation de tension par rapport à au moins un autre fonctionnement du système haute tension (2) et/ou du véhicule automobile (26).

7. Système haute tension selon la revendication 6, **caractérisé en ce que** :
le dispositif de mesure (16) mesure la variation de tension dans un moteur électrique (6) du véhicule automobile (26) et/ou le dispositif de commande (15) est conformé pour réguler le moteur électrique (6) du véhicule automobile (26) en fonction de la variation de tension.

8. Système haute tension selon l'une quelconque des revendications précédentes, **caractérisé par** une résistance de série (10) aménagée sur une sortie de la batterie pour le chargement contrôlé de la capacité (7).

9. Procédé de diagnostic d'un système haute tension pour un véhicule automobile, en particulier d'un système haute tension selon l'une quelconque des revendications 1 à 6, comprenant une batterie haute tension alimentant au moins une charge, en particulier un onduleur, via des lignes, batterie dont la tension est supérieure à 60 volts, au moins un commutateur pour séparer la batterie haute tension de la charge, un condensateur commuté en parallèle avec la charge et un circuit de décharge pour décharger le condensateur par une résistance de décharge et un commutateur de décharge fermant le circuit de décharge,
dans lequel on mesure une courbe de tension décrivant la variation de tension sur le condensateur au cours de la phase de décharge, laquelle variation de tension est évaluée au regard d'un fonctionnement défectueux du circuit de décharge,
**caractérisé en ce que** :
la phase de décharge est interrompue pendant un intervalle de temps prédéterminé par commande du commutateur de décharge et l'on détecte un fonctionnement défectueux lors de la mesure d'une tension qui se trouve en dehors d'une zone de seuil au regard de la tension apparaissant au moment de l'interruption.

10. Procédé selon la revendication 9,
**caractérisé en ce que** :
un fonctionnement défectueux est détecté lors du dépassement d'un valeur de seuil temporelle par le temps s'écoulant jusqu'à atteindre une tension limite se situant en dessous de la tension de sortie de la batterie haute tension après fermeture du commutateur de décharge.

11. Procédé selon l'une quelconque des revendications 9 ou 10,
**caractérisé en ce que** :
un message d'erreur n'est produit que lors du dépassement d'une valeur de seuil de sécurité pour le nombre de fonctionnements défectueux, en particulier le nombre de fonctionnements défectueux d'un type.

12. Procédé selon l'une quelconque des revendications 9 à 11,
**caractérisé en ce que** :
la mesure et l'évaluation sont réalisées lors de chaque séparation de la batterie haute tension de la charge.

13. Procédé selon l'une quelconque des revendications 9 à 12,
**caractérisé en ce que** :
la variation de tension est évaluée également par rapport à au moins un autre fonctionnement du système haute tension et/ou du véhicule automobile, en particulier par rapport à la régulation d'un moteur électrique du véhicule automobile.

14. Véhicule automobile (26) comprenant un système haute tension (1) selon l'une quelconque des revendications 1 à 8.
